# EUROPEAN PATENT APPLICATION

(11) **EP 4 687 400 A1**
(43) Date of publication of application: **04.02.2026**
(21) Application number: 25179714.8
(22) Date of filing: 29.05.2025
(51) Int. Cl.: H10F 10/165, H10F 71/00, H10F 77/20

(54) **SOLAR CELL AND PREPARATION METHOD THEREFOR AND PHOTOVOLTAIC MODULE**

(30) Priority: 31.07.2024 CN 202411044983
(71) Applicant: Tongwei Solar (Chengdu) Co., Ltd., Chengdu, Sichuan 610299 (CN)
(72) Inventor: CHEN, Yang, Chengdu, 610299 (CN); FAN, Jianbin, Chengdu, 610299 (CN); MENG, Xiajie, Chengdu, 610299 (CN)
(74) Representative: Gill Jennings & Every LLP

(57) **Abstract**

A solar cell includes: a silicon substrate; a first semiconductor layer and a second semiconductor layer provided on the silicon substrate, the first semiconductor layer being doped with an N-type conductive element, and the second semiconductor layer being doped with a P-type conductive element; a first electrode electrically connected to the first semiconductor layer through a plurality of first conductive structures; and a second electrode electrically connected to the second semiconductor layer through a plurality of second conductive structures; wherein a density of the plurality of first conductive structures is greater than a density of the plurality of second conductive structures.

## Description

### TECHNICAL FIELD

The present invention relates to the field of solar cells, particularly to a solar cell, a preparation method therefor, and a photovoltaic module.

### BACKGROUND

In solar cells, the capacity of carriers to transport between the semiconductor layer and the electrode has a significant impact on the photoelectric conversion efficiency of the solar cell. If the resistance encountered by the carriers during their transport to the electrode is relatively high, it can increase the probability of contact between the carriers and defects and impurities in the semiconductor layer. This can increase the probability of carrier scattering, and lead to more carrier recombination, thereby limiting further improvements in the photoelectric conversion efficiency of the solar cells.

### SUMMARY

Embodiments of the present invention disclose a solar cell, a preparation method therefor, and a photovoltaic module, which can improve the efficiency of carrier transport, reduce recombination, and lower scattering, thereby further improving the photoelectric conversion efficiency of the solar cell.

In a first aspect, a solar cell includes:
a silicon substrate;
a first semiconductor layer and a second semiconductor layer provided on the silicon substrate, the first semiconductor layer being doped with an N-type conductive element, and the second semiconductor layer being doped with a P-type conductive element;
a first electrode electrically connected to the first semiconductor layer through a plurality of first conductive structures; and
a second electrode electrically connected to the second semiconductor layer through a plurality of second conductive structures;
wherein a density of the plurality of first conductive structures is greater than a density of the plurality of second conductive structures.

In some embodiments, in any contact region of 1 mm × 1 mm between the first electrode and the first semiconductor layer, a number of the first conductive structures is in a range from 1×10⁵ to 1×10⁶; and in any contact region of 1 mm × 1 mm between the second electrode and the second semiconductor layer, a number of the plurality of second conductive structures is in a range from 5×10⁴ to 5×10⁵.

In some embodiments, a size of a projection of each first conductive structure on the first semiconductor layer is greater than or equal to a size of a projection of each second conductive structure on the second semiconductor layer, the size of the projection of the first conductive structure on the first semiconductor layer is in a range from 100 nm to 2000 nm, and the size of the projection of the second conductive structure on the second semiconductor layer is in a range from 100 nm to 1000 nm.

In some embodiments, each first conductive structure and each second conductive structure are shaped as a leaf vein.

In some embodiments, the first conductive structure includes a plurality of strip-shaped first structures diverging toward the first electrode, and the second conductive structure includes a plurality of strip-shaped second structures diverging toward the second electrode.

In some embodiments, each first structure includes a first crystalline main chain and a plurality of first crystalline side chains extending in directions different from a growth direction of the first crystalline main chain, and each second structure includes a second crystallization main chain and a plurality of second crystallization side chains extending in directions different from a growth direction of the second crystallization main chain.

In some embodiments, the first structure and the second structure are both formed by crystallization and polymerization of a plurality of conductive particles.

In some embodiments, an element in each conductive particle comprises silver, aluminum, copper, lead, or any combination thereof.

In some embodiments, a doping concentration of the N-type conductive element in the first semiconductor layer is in a range from 1×10²⁰ atoms/cm³ to 1×10²¹ atoms/cm³, and a doping concentration of the P-type conductive element in the second semiconductor layer is in a range from 1×10¹⁸ atoms/cm³ to 1×10²⁰ atoms/cm³.

In some embodiments, the first semiconductor layer and the second semiconductor layer are provided on a backlight surface of the silicon substrate, the first semiconductor layer and second semiconductor layer are separated by an isolation region, and the first semiconductor layer and second semiconductor layer are arranged in an interdigitated shape.

In some embodiments, the solar cell further includes a first dielectric layer provided between the first semiconductor layer and the silicon substrate, and a second dielectric layer provided between the second semiconductor layer and the silicon substrate.

In some embodiments, the silicon substrate is an N-type substrate, the second semiconductor layer is provided on a light receiving surface of the silicon substrate, the first semiconductor layer is provided on a backlight surface of the silicon substrate, and the solar cell further includes a first dielectric layer provided between the first semiconductor layer and the silicon substrate.

In some embodiments, the solar cell further includes a plurality of first semiconductor layers provided on the backlight surface, wherein each first semiconductor layer is provided on a partial region of the backlight surface, and adjacent two first semiconductor layers are separated by a first separation region.

In some embodiments, the solar cell further includes a plurality of second semiconductor layers provided on the light receiving surface, wherein each second semiconductor layer is provided on a partial region of the light receiving surface, adjacent two second semiconductor layers are separated by a second separation region, and the second separation region is provided with a textured structure.

In a second aspect, a method for preparing the solar cell as described in the first aspect includes:
providing a silicon substrate;
forming a first semiconductor layer and a second semiconductor layer on the silicon substrate;
applying a first paste onto the first semiconductor layer and applying a second paste onto the second semiconductor layer;
heating the first paste and the second paste to form a first electrode and a second electrode, respectively, such that a contact interface between the first electrode and the first semiconductor layer forms a first conductive precursor, and a contact interface between the second electrode and the second semiconductor layer forms a second conductive precursor; and
performing light injection, such that the first conductive precursor is converted into a first conductive structure, and the second conductive precursor is converted into a second conductive structure, thereby obtaining the solar cell.

In some embodiments, performing light injection includes:
heating the first and second conductive precursors, wherein a peak temperature of the heating is in a range from 400°C to 650°C; and
subjecting the solar cell to light irradiation when a temperature of the heating drops from the peak temperature to a preset temperature, wherein a temperature of the light irradiation is in a range from 50°C to 400°C, an energy density of the light irradiation is in a range from 10 kW/m² to 100 kW/m², and the preset temperature is in a range from 320°C to 360°C.

In some embodiment, the heating the first and second conductive precursors includes:
heating the first and second conductive precursors to the preset temperature, and
heating the first and second conductive precursors from the preset temperature to the peak temperature within a preset time, and cooling the first and second conductive precursors to the preset temperature, wherein the present time is in a range from 10 seconds to 30 seconds.

In some embodiments, the first conductive precursor includes a plurality of first crystalline main chains diverging toward the first electrode, and the second conductive precursor includes a plurality of second crystalline main chains diverging toward the second electrode.

In some embodiments, a temperature of heating the first paste and the second paste is in a range from 700°C to 900°C.

In some embodiments, forming the first semiconductor layer and the second semiconductor layer on the silicon substrate includes:
depositing a second dielectric layer and the second semiconductor layer sequentially on a backlight surface of the silicon substrate;
patterning the second dielectric layer and the second semiconductor layer to expose a part of the backlight surface;
depositing a first dielectric layer and the first semiconductor layer sequentially on an exposed backlight surface and the second semiconductor layer; and
removing the first semiconductor layer and the first dielectric layer on the second semiconductor layer, and forming an isolation region between adjacent second semiconductor layer and first semiconductor layer.

In some embodiment, providing the silicon substrate includes:
depositing a second semiconductor layer on a light receiving surface of the silicon substrate;
depositing a first dielectric layer and a first semiconductor layer sequentially on a backlight surface of the silicon substrate.

In a third aspect, an embodiment of the present invention provides a photovoltaic module, including the solar cell as described in the first aspect, or the solar cell prepared by the method as described in the second aspect.

Compared to the prior art, the solar cell according to the aforementioned embodiments can improve the efficiency of carrier transport, reduce recombination, and lower scattering, thereby further improving the photoelectric conversion efficiency of the solar cell.

In the above solar cell structure, since the first semiconductor layer is doped with an N-type conductive element and the second semiconductor layer is doped with a P-type conductive element, the diffusion capability of carriers in the first semiconductor layer is higher than the diffusion capability of carriers in in the second semiconductor layer. In this case, when the carriers in the first semiconductor layer cannot be effectively transported to the first electrode, the probability of contact between carriers in the first semiconductor layer and impurities or defects increases, leading to increased scattering and severe recombination of carriers in the first semiconductor layer. Therefore, to improve the effectiveness of carrier transport in the first semiconductor layer, the density of the first conductive structure is designed to be greater than the density of the second conductive structure, so that the distribution of the first conductive structure is relatively dense, providing multiple paths for carrier transport. These decreases contact resistance, and conduces to reducing the carrier transport barrier between the first semiconductor layer and the first electrode, enhancing carrier mobility, diminishing carrier scattering, and lowering carrier recombination, thereby improving the photoelectric conversion efficiency of the solar cell.

In other words, by designing the densities of the first conductive structure and the second conductive structure, the effectiveness of carrier transmission between the first semiconductor layer and the first conductive structure is improved, recombination is reduced, and scattering is minimized, thereby enhancing the photoelectric conversion efficiency of the solar cell.

### BRIEF DESCRIPTION OF THE DRAWINGS

In order to illustrate the embodiments of the present invention more clearly, the drawings used in the embodiments will be described briefly. Apparently, the following described drawings are merely for the embodiments of the present invention, and other drawings can be derived by those of ordinary skill in the art without any creative effort.
FIG. 1 is a schematic structural view of a first solar cell according to an embodiment of the present invention.
FIG. 2 is an enlarged view of section A in FIG. 1.
FIG. 3 is an enlarged view of section B in FIG. 1.
FIG. 4 is a schematic structural view of a first conductive structure according to an embodiment of the present invention.
FIG. 5 is a schematic structural view of a first structure according to an embodiment of the present invention.
FIG. 6 is a schematic structural view of a second solar cell according to an embodiment of the present invention.
FIG. 7 is a schematic structural view of a third solar cell according to an embodiment of the present invention.
FIG. 8 is a scanning electron microscope image of a first conductive precursor according to an embodiment of the present invention.
FIG. 9 is a scanning electron microscope image of a second conductive structure according to an embodiment of the present invention.
FIG. 10 is a scanning electron microscope image of a second conductive precursor according to an embodiment of the present invention.
FIG. 11 is a scanning electron microscope image of a second conductive structure according to an embodiment of the present invention.

### Reference signs:

1: silicon substrate; 21: first semiconductor layer; 22: second semiconductor layer; 31: first electrode; 32: second electrode; 41: first conductive structure; 411: first structure; 4111: first crystalline main chain; 4112: first crystalline side chain; 42: second conductive structure; 51: first dielectric layer; 52: first dielectric layer; 61: first functional layer; 62: second functional layer; 63: third functional layer; 7: first separation region; 8: second separation region.

### DETAILED DESCRIPTION

The technical solutions of the embodiments of the present invention will be described more clearly and comprehensively below in conjunction with the accompanying drawings for the embodiments of the present invention. Apparently, the embodiments described herein are only part of, not all of the embodiments of the present invention. Base on the embodiments of the present invention, other embodiments obtained by those of ordinary skill in the art without creative efforts shall fall within the protection scope of the present invention.

In the present invention, the orientation or position relationships indicated by the terms "upper", "lower", "left", "right", "front", "back", "top", "bottom", "inner", "outer", "middle" "vertical", "horizontal", "transverse", "longitudinal" and the like are based on the orientation or position relationships shown in the accompanying drawings. These terms are intended to facilitate the description of the present invention and the embodiments thereof, rather than indicating or implying that the apparatus, element, or part referred to must have a particular orientation or be constructed and operated in a particular orientation.

Moreover, some of the above terms can also be used to express other meanings besides indicating the orientation or position relationships. For example, the term "upper" can also indicate a certain dependency or connection relationship in some cases. For those of ordinary skill in the art, the specific meanings of these terms in the present invention can be understood based on a specific condition.

Additionally, the terms "first", "second", and the like are primarily used to distinguish different devices, elements, or parts (which can or cannot be of the same type or structure), and are not intended to indicate or imply the relative importance or quantity of the indicated devices, components, or parts. Unless otherwise specified, "a plurality of" means two or more.

The technical solutions provided in the present invention will be further illustrated below with reference to the embodiments and accompanying drawings.

In solar cells, the concentration and transport capability of charge carriers have a significant impact on the performance of the solar cell, such as the photoelectric conversion efficiency.

Since the mobility of electrons is higher than that of holes, under the same electric field, electrons have a faster transport rate and can participate in the electric conduction process more effectively. However, if electrons are difficult to transport to the electrodes, the probability of electrons encountering impurities or defects in the semiconductor layer increases, thereby increasing the probability of electron scattering and recombination, making it difficult to effectively improve the conductive performance of the solar cell.

Based on the above issues, embodiments of the present invention provides a solar cell that can enhance the mobility of carriers, reduce recombination, and thereby improve the photoelectric conversion efficiency of the solar cell.

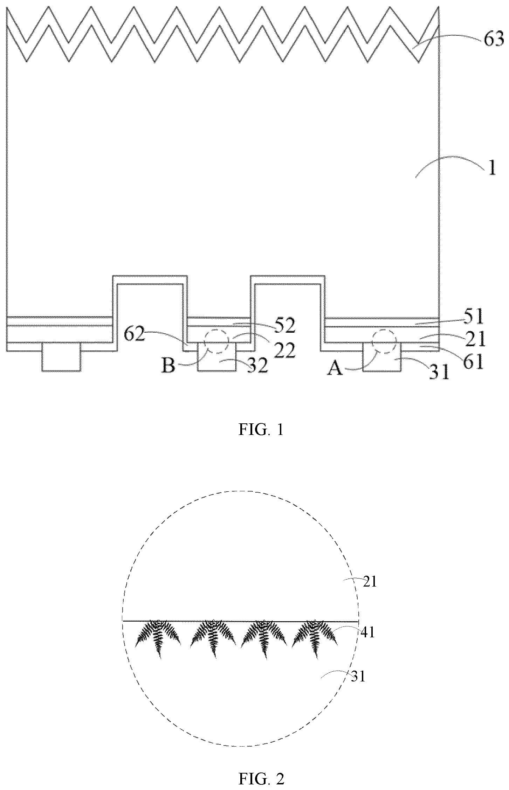

In a first aspect, as shown in FIGS. 1 to 3, an embodiment of the present invention provides a solar cell, which includes: a silicon substrate 1; a first semiconductor layer 21 and a second semiconductor layer 22 that are provided on the silicon substrate 1, the first semiconductor layer 21 being doped with an N-type conductive element, and the second semiconductor layer 22 being doped with a P-type conductive element; a first electrode 31 electrically connected to the first semiconductor layer 21 through a plurality of first conductive structures 41; and a second electrode 32 electrically connected to the second semiconductor layer 22 through a plurality of second conductive structures 42. A density of the plurality of first conductive structures 41 is greater than a density of the plurality of second conductive structures 42.

The "density" used herein refers to the quality or state of being dense of the first conductive structures 41 or the second conductive structures 42 in a standard region.

In the present invention, by configuring the density of the first conductive structures 41 to be higher than that of the second conductive structures 42, the distribution density of the first conductive structures 41 is increased, thus providing multiple paths for carrier transport. This is conducive to decreasing contact resistance, reducing the carrier transport barrier between the first semiconductor layer 21 and the first electrode 31, enhancing carrier mobility, diminishing carrier scattering, and conduces to lowering recombination, thereby improving the photoelectric conversion efficiency of the solar cell.

Moreover, in solar cells, a doping concentration of the N-type conductive element in the first semiconductor layer is generally higher than that of the P-type conductive element in the second semiconductor layer. The higher doping concentration of the N-type conductive element increases the concentration of carriers. However, if the carriers cannot be effectively transported to the electrode, the probability of carrier scattering and recombination increases. Therefore, in the present invention, the density of the first conductive structures is configured to be higher than that of the second conductive structures, thereby enabling the carriers to be efficiently transported to the first electrode through the first conductive structures, reducing carrier recombination and scattering, and improving the photoelectric conversion efficiency of the solar cell.

In summary, by designing the densities of the first conductive structures 41 and the second conductive structures 42, the impact of a relatively high diffusion rate of carriers in the first semiconductor layer on carrier scattering and recombination can be further avoided, such that the carriers are effectively transmitted to the electrodes, and the performance of the solar cell is improved. That is, the mutual synergy between the semiconductor layer and the conductive structure is conducive to enhancing the stability of contact between the semiconductor layer and the electrode, decreasing contact resistance, enhancing carrier mobility, lowering carrier recombination, and raising conductivity, thereby improving the photoelectric conversion efficiency of the solar cell.

A type of carriers provided by the N-type conductive element is an electron, and the N-type conductive element includes at least one of phosphorus or arsenic. A type of carriers provided by the P-type conductive element is a hole, and the P-type conductive element includes at least one of boron or gallium.

Further, in any contact region of 1 mm × 1 mm between the first electrode 31 and the first semiconductor layer 21, the number of the first conductive structures 41 is in a range from 1×10⁵ to 1×10⁶. In any contact region of 1 mm × 1 mm between the second electrode 32 and the second semiconductor layer 22, the number of the plurality of second conductive structures 42 is in a range from 5×10⁴ to 5×10⁵.

When the quantities of the first conductive structures 41 and the second conductive structures 42 in the contact region satisfy the above ranges, a contact area between the electrode and semiconductor layer is suitable, which can effectively decrease the contact resistance and enhance carrier transport. This can not only avoid the difficulty of improving carrier transport efficiency due to an insufficient quantity, but also can avoid the issues such as damage or severe contamination in the contact regions caused by oversized contact area between the electrode and semiconductor layer resulting from an excessive quantity to reduce carrier recombination, thereby improving the performance of the solar cell.

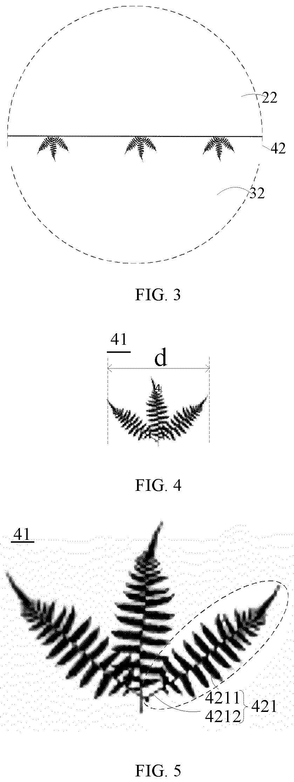

Further, referring to FIGS. 2 and 3, a size of a projection of each first conductive structure 41 on the first semiconductor layer 21 is greater than or equal to a size of a projection of each second conductive structure 42 on the second semiconductor layer 22. The size of the projection of each first conductive structure 41 on the first semiconductor layer 21 is in a range from 100 nm to 2000 nm, and the size of the projection of each second conductive structure 42 on the second semiconductor layer 22 is in a range from 100 nm to 1000 nm.

It should be noted that, taking the first conductive structure 41 as an example, as shown in FIG. 4, the size of the projection of the first conductive structure 41 refers to a width d between the two farthest points where the first conductive structure 41 diverges and expands outward. Similarly, the size of the projection of the second conductive structure 42 refers to a width between the two farthest points where the second conductive structure 42 diverges and expands outward.

When the sizes of the projections of the first conductive structure 41 and the second conductive structure 42 are within the above ranges, it can not only ensure good carrier transport capability but can also reduce the damage range at the contact interface between the semiconductor layer and the electrode, as well as lower contact recombination, thus improving the contact performance between the semiconductor layer and the electrode. Moreover, since the doping concentration of the second semiconductor layer 22 is relatively low, when the size of the projection of the second conductive structure 42 is less than that of the first conductive structure 41, it is conducive to decreasing defects at the contact interface, thus further lowering the carrier recombination. Additionally, due to the greater size of the projection of the first conductive structure 41, the transport rate of carriers in the first semiconductor layer 21 is improved to a relatively high extent, carrier scattering is diminished, the photoelectric conversion efficiency of the solar cell is improved, and the consumption of paste can be lowered, thereby reducing usage costs of the paste.

Further, in order to further enhance carrier mobility, each first conductive structure 41 and each second conductive structure 42 are shaped as a leaf vein. This structure can not only increase the contact area between any conductive structure and the semiconductor layer, but also provides carrier transport paths in various directions, which not only ensures uniform carrier transport but also can reduce resistance losses, thereby enhancing the photoelectric conversion efficiency of the solar cell. Moreover, it is conducive to improving the stability of the contact between the electrode and the semiconductor layer, thus ensuring good contact performance during welding and related stability tests for the cells or modules.

Further, as shown in FIG. 5, each first conductive structure 41 includes a plurality of strip-shaped first structures 411 diverging toward the first electrode 31. Each second conductive structure 42 includes a plurality of strip-shaped second structures diverging toward the second electrode 32. The large number of the first structures 411 and the second structures are conducive to ensure that the first conductive structure 41 and the second conductive structure 42 can provide relatively more carrier transport paths, thereby enhancing carrier mobility.

Additionally, each first structure 411 includes a first crystalline main chain 4111 and a plurality of first crystalline side chains 4112 extending in directions different from a growth direction of the first crystalline main chain 4111. Each second structure includes a second crystallization main chain and a plurality of second crystallization side chains extending in directions different from a growth direction of the second crystallization main chain. The large number of first crystalline side chains 4112 and second crystallization side chains are conducive to ensure that the first conductive structure 41 and the second conductive structure 42 can provide relatively more carrier transport paths, thereby enhancing carrier mobility and reducing recombination.

Specifically, referring to FIG. 5, taking the first conductive structure 41 as an example, the first conductive structure 41 includes a plurality of first structures 411, and each first structures 411 consists of one first crystalline main chain 4111 and a plurality of first crystalline side chains 4112. Therefore, the carriers in the first semiconductor layer 21 can not only transport along the first crystalline main chain 4111, but also can transport along the first crystalline side chains 4112. Moreover, since the number of first crystalline main chains 4111 and first crystalline side chains 4112 in the first conductive structure 41 is large, it is conducive to ensuring relatively great contact area between the first electrode 31 and the first semiconductor layer 21, and reducing contact resistance. In addition, a plurality of transport paths can be provided, thus enhancing carrier mobility to a relatively high extent, ensuring uniform carrier transport, and reducing recombination. Furthermore, the structural characteristics of the first conductive structure 41 enhance the bonding stability between the first electrode 31 and the first semiconductor layer 21, which is conducive to increasing the stability of subsequent photovoltaic module welding and significantly improving the performance of the solar cell.

Further, the first structure 411 and the second structure are both formed by crystallization and polymerization of a plurality of conductive particles, and an element in each conductive particle includes silver, aluminum, copper, lead, or any combination thereof.

Additionally, in order to ensure good conductivity of the solar cell, a doping concentration of the N-type conductive element in the first semiconductor layer 21 is in a range from 1×10²⁰ atoms/cm³ to 1×10²¹ atoms/cm³, and a doping concentration of the P-type conductive element in the second semiconductor layer 22 is in a range from 1×10¹⁸ atoms/cm³ to 1×10²⁰ atoms/cm³. By controlling the doping concentration of the conductive elements within these ranges, the concentration of a carrier matches the quantity of conductive structures, thereby effectively enhancing the conductivity of the solar cell and preventing the adverse impact of high-concentration doping on carrier transport, which enhances carrier mobility, reduces recombination, and improves the photoelectric conversion efficiency of the solar cell.

In a first optional embodiment, referring to FIG. 1, the solar cell is a back-contact cell. The first semiconductor layer 21 and the second semiconductor layer 22 are provided on a backlight surface of the silicon substrate 1. The first semiconductor layer 21 and second semiconductor layer 22 are separated by an isolation region, and the first semiconductor layer 21 and second semiconductor layer 22 are arranged in an interdigitated shape.

For back-contact cells, since both positive and negative electrodes are located on the backlight surface, and the light receiving surface is not shielded by the metal grid, the electrode-induced shading losses are avoided, and the recombination on the light receiving surface is reduced, thereby improving the solar cell's photoelectric conversion efficiency.

In order to further enhance the performance of the solar cell, a passivation contact structure can be provided on the backlight surface. In one embodiment, the solar cell further includes a first dielectric layer 51 provided between the first semiconductor layer 21 and the silicon substrate 1, and a second dielectric layer 52 provided between the second semiconductor layer 22 and the silicon substrate 1.

Since the solar cell includes the dielectric layers and the semiconductor layers, their combination forms the passivation contact structure, thus providing an excellent interface passivating effect on the backlight surface. The material of the dielectric layer can include various dielectric materials, such as at least one of silicon oxide, magnesium fluoride, amorphous silicon, polycrystalline silicon, silicon carbide, silicon nitride, silicon oxynitride, aluminum oxide, or titanium oxide. In one embodiment, the dielectric layer is a silicon oxide layer prepared from silicon oxide. Since the silicon oxide layer has outstanding passivation performance, it can minimize the recombination loss of minority carriers on the surface of the silicon substrate, and serves as a thin film with excellent durability for subsequent high-temperature processes.

The dielectric layer acts as a potential barrier for electrons and holes, and can be combined with the semiconductor layer to form a passivation contact structure, thereby preventing minority carriers from passing through. The dielectric layer can also function as a pinhole channel allowing the carriers in the solar cell to move freely, and enabling the selective passage of majority carriers through the heavily doped semiconductor layer, which is beneficial for reducing the recombination loss of the minority carriers. In addition, the dielectric layer can serve as a diffusion barrier for preventing the conductive element of the semiconductor layer from diffusing into the silicon substrate. Moreover, the thickness of the dielectric layer is controlled to be within a range of 0.5 nm to 4 nm, which is beneficial for reducing the hindrance of carrier transport and improving its transport efficiency.

Furthermore, a first functional layer 61 is provided on the first semiconductor layer 21, and a second functional layer 62 is provided on the second semiconductor layer 22, which can further improve the performance of the solar cell. The first functional layer 61 is a first passivation layer and/or a first anti-reflection layer. The second functional layer 62 is a second passivation layer and/or a second anti-reflection layer.

Moreover, since both the first semiconductor layer 21 and the second semiconductor layer 22 are located on the backlight surface of the silicon substrate 1, i.e., the first functional layer 61 and the second functional layer 62 are both located on the backlight surface of the solar cell, in this case, the first functional layer 61 and the second functional layer 62 are prepared in the same processing step and are therefore the same type of film layer. Additionally, in order to further enhance the photoelectric conversion efficiency of the solar cell, a third functional layer 63 is further provided on the light receiving surface of the silicon substrate 1.

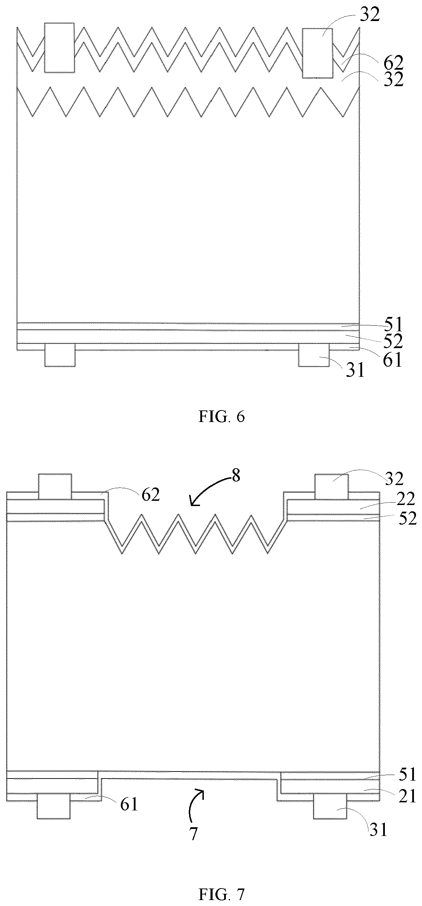

In a second optional embodiment, as shown in FIGS. 6 and 7, the solar cell is a passivated contact cell. The silicon substrate 1 is an N-type substrate, the second semiconductor layer 22 is provided on the light receiving surface of the silicon substrate 1, and the first semiconductor layer 21 is provided on the backlight surface of the silicon substrate 1. A first dielectric layer 51 is provided between the first semiconductor layer 21 and the silicon substrate 1.

Referring back to FIG. 7, in order to further enhance the passivation effect and improve the photoelectric conversion efficiency of the solar cell, in one embodiment, a plurality of first semiconductor layers 21 is provided on the backlight surface. Each first semiconductor layer 21 is provided on a partial region of the backlight surface, and adjacent two first semiconductor layers 21 are separated by a first separation region 7. Alternatively, a plurality of second semiconductor layers 22 are provided on the light receiving surface. Each second semiconductor layer 22 is provided on a partial region of the light receiving surface, and adjacent two second semiconductor layers 22 are separated by a second separation region 8. The second separation region 8 is provided with a textured structure. When both the light receiving surface and the backlight surface are provided with local passivation structures, the light receiving surface achieves high passivation effect with minimal impact on light absorption, while the local passivation structure on the backlight surface is conducive to reducing production costs, minimizing contact damage between the semiconductor layer and the silicon substrate 1, and improving photoelectric conversion efficiency of the solar cell.

Furthermore, in order to enhance passivation effect on the light receiving surface, a second dielectric layer 52 can be provided on the light receiving surface, and the second dielectric layer 52 is located between the second semiconductor layer 22 and the silicon sub strate 1.

Additionally, a first functional layer 61 is formed on the side of the first semiconductor layer 21 away from the silicon substrate 1, and a second functional layer 62 is formed on the side of the second semiconductor layer 22 away from the silicon substrate 1. The first functional layer 61 is a first passivation layer and/or a first anti-reflection layer, and the second functional layer 62 is a second passivation layer and/or a second anti-reflection layer.

The passivation layer is conducive to reducing surface recombination, and improving the solar cell's photoelectric conversion efficiency. The anti-reflection layer can not only reduce the reflection of the incident light, but also contributes to passivation, thus further enhancing photoelectric conversion efficiency. For example, the first functional layer 61 can be the first passivation layer, the first anti-reflection layer, or the first passivation layer and first anti-reflection layer, while the second functional layer 62 can be the second anti-reflection layer, the second passivation layer, or the second anti-reflection layer and the second passivation layer.

When the functional layers are provided on the first semiconductor layer 21 and the second semiconductor layer 22, it is conducive to improving the photoelectric conversion efficiency of the solar cell. The first electrode 31 can extend through the first functional layer 61 and is connected to the first semiconductor layer 21 via a first conductive structure 41. The second electrode 32 can extend through the second functional layer 62 and is connected to the second semiconductor layer 22 via a second conductive structure 42. In this case, the second semiconductor layer 22 is located on the light receiving surface of the solar cell, therefore, the second functional layer 62 is located on both the second semiconductor layer 22 and the exposed textured structure, and the first functional layer 61 is located on the first semiconductor layer 21 and the exposed backlight surface.

The first functional layer 61 includes at least one of aluminum oxide, silicon oxide, silicon oxynitride, or silicon nitride. The second functional layer 62 includes at least one of aluminum oxide, silicon oxide, silicon oxynitride, or silicon nitride.

In a second aspect, an embodiment of the present invention further provides a method for preparing a solar cell. The preparation method includes the following steps:
providing a silicon substrate;
forming a first semiconductor layer and a second semiconductor layer on the silicon substrate;
applying a first paste onto the first semiconductor layer and applying a second paste onto the second semiconductor layer;
heating the first paste and the second paste to form a first electrode and a second electrode, respectively, such that a contact interface between the first electrode and the first semiconductor layer forms a first conductive precursor, and a contact interface between the second electrode and the second semiconductor layer forms a second conductive precursor; and
performing light injection, such that the first conductive precursor is converted into a first conductive structure, and the second conductive precursor is converted into a second conductive structure, thereby obtaining the solar cell.

The pastes can be applied to the semiconductor layers by screen printing.

It should be understood that, the paste includes a conductive particle, a glass frit, an organic solvent, and a binder. The conductive particle exhibits excellent conductivity, enabling crystals to form a strong contact with the semiconductor layer during the heating the first paste and the second paste, ensuring an efficient current transport. The glass frit facilitates the fusion and combination of the conductive particle with the semiconductor layer during the heating the first paste and the second paste and promote the conductive particle to pass through the functional layer to contact with the semiconductor layer. The organic solvent and the binder adjust the fluidity of the paste, reducing printing difficulty and improving printing quality.

Furthermore, each first conductive precursor includes a plurality of first crystalline main chains diverging toward the first electrode, and each second conductive precursor includes a plurality of second crystalline main chains diverging toward the second electrode.

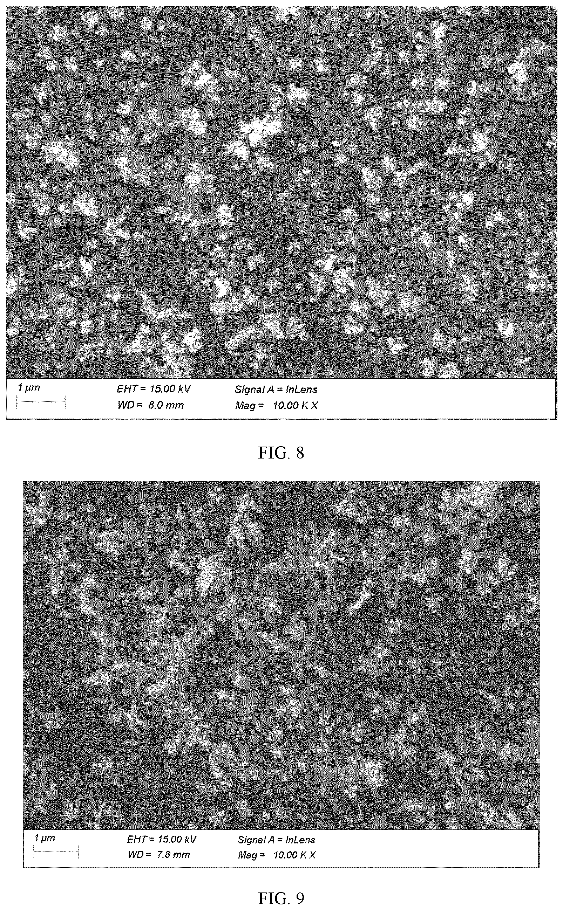

As shown in FIG. 8, during the heating the first paste and the second paste, in the first paste for forming the first electrode, conductive particles are retained after the evaporation and release of the organic solvent and the binder, some of the conductive particles further crystallize and aggregate, forming the first conductive precursor at the contact interface between the first electrode and the first semiconductor layer after the crystallization of these conductive particles. The structure of the first conductive precursor is presented as a plurality of first crystalline main chains diverging toward the first electrode. As shown in FIG. 9, during the subsequent light injection, some conductive particles aggregate and grow along directions different from the grow direction of the first crystalline main chain to form a plurality of slender first crystalline side chains under the action of high-temperature and intense light-induced catalytic reduction, thereby forming a first conductive structure in a leaf vein shape.

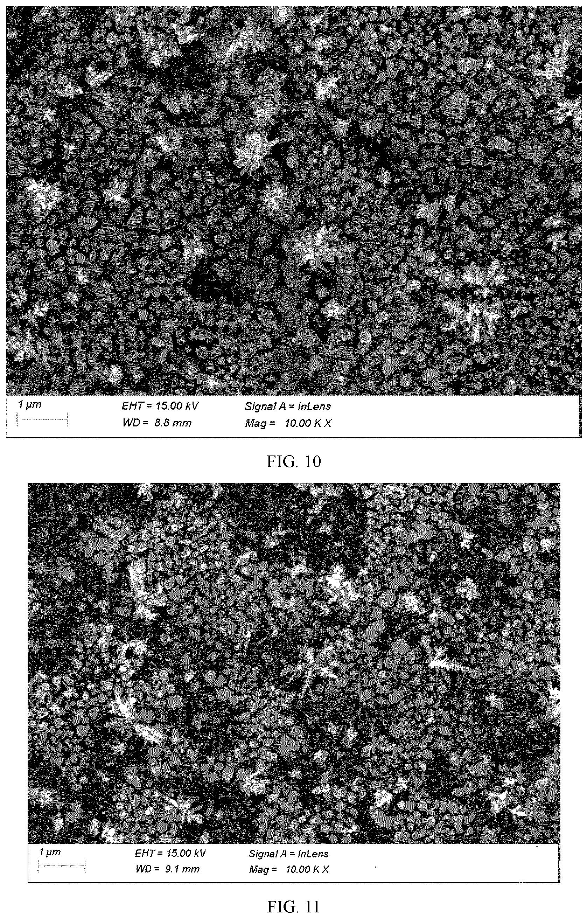

As shown in FIG. 10, during the heating the first paste and the second paste, in the second paste for forming the second electrode, conductive particles are retained after the evaporation and release of the organic solvent and the binder, some of the conductive particles further crystallize and aggregate, forming the second conductive precursor at the contact interface between the second electrode and the second semiconductor layer after the crystallization of these conductive particles. The structure of the second conductive precursor appears as a plurality of second crystalline main chains diverging toward the second electrode. As shown in FIG. 11, during the subsequent light injection, some conductive particles aggregate and grow along directions different from the grow direction of the second crystalline main chain to form a plurality of slender second crystalline side chains under the action of high-temperature and intense light-induced catalytic reduction, thereby forming a second conductive structure in a leaf vein shape.

In other words, the step of the light injection enables some conductive particles to aggregate and grow on the crystalline main chains to form crystalline side chains. This means that the first conductive precursor is converted to the first conductive structure, and the first electrode is connected to the first semiconductor layer, and means that the second conductive precursor is converted to the second conductive structure, and the second electrode is connected to the second semiconductor layer. The aforementioned preparation method ensures that the density of the resulting second microstructure is lower than that of the first microstructure, which can improve carrier transport capacity to a relatively high extent.

Further, the step of the light injection includes:
heating the first and second conductive precursors, and a peak temperature of the heating is in a range from 400°C to 650°C;
subjecting the solar cell to light irradiation when a temperature of the heating drops from the peak temperature to a preset temperature. A temperature of the light irradiation is in a range from 50°C to 400°C, and an energy density of the light irradiation is in a range from 10 kW/m² to 100 kW/m². The preset temperature is in a range from 320°C to 360°C.

When the parameters in the light injection are controlled within the above ranges, they facilitate the diffusion and the crystallization and aggregation of the conductive particles, allowing the parameters of the first and second conductive structures to be within the ranges of the present invention, thereby conducing to reducing contact resistance and improving carrier transport efficiency.

Further, the heating the first and second conductive precursors includes the following steps: heating the first and second conductive precursors to the preset temperature, and heating the first and second conductive precursors from the preset temperature to the peak temperature within a preset time, and cooling the first and second conductive precursors to the preset temperature, wherein the present time is in a range from 10 seconds to 30 seconds. Since the glass frit solvent is in a softened state during the heating phase, the conductive particles can be distributed uniformly within the glass frit. Further, by controlling the preset time within the above range, there is sufficient time for the conductive particles to move, aggregate, and to be reduced to form conductive structures, thus ensuring that the resulting first and second conductive structures satisfy the ranges of the present invention.

Further, during the step of the heat treatment, a temperature of the heat treatment is in a range from 700°C to 900°C. Controlling the heat treatment temperature within this range promotes the diffusion and combination of the conductive particles, facilitating the formation of the conductive precursors and ensuring the structures of the resulting conductive precursors meet the requirements of the present invention.

Further, after the step of applying the first electrode paste onto the first semiconductor layer and prior to applying the second electrode paste onto the second semiconductor layer, the preparation method further includes: drying the first electrode paste at a temperature of 100°C to 300°C.

Alternatively, after applying the second electrode paste onto the second semiconductor layer and prior to the step of the heat treatment, the preparation method further includes: drying the second electrode paste at a temperature of 100°C to 300°C.

Drying the pastes before the heat treatment allows for the evaporation of part of organic solvent, thereby reducing the humidity of the pastes. Thus this prevents the poor stability of the electrode structure caused by rapid evaporation of the organic solvent during the heating the first paste and the second paste, which leads to the poor stability of the contact area between the electrode and the semiconductor layer, and the formation of many defects in the contact area, and difficulties in effectively improving the photoelectric conversion performance of the solar cell.

In a first optional embodiment, forming the first semiconductor layer and the second semiconductor layer on the silicon substrate includes:
depositing a second dielectric layer and the second semiconductor layer sequentially on the backlight surface of the silicon substrate;
patterning the second dielectric layer and the second semiconductor layer to expose a part of the backlight surface;
depositing a first dielectric layer and the first semiconductor layer sequentially on the exposed backlight surface and the second semiconductor layer; and
removing the first semiconductor layer and the first dielectric layer on the second semiconductor layer, and forming an isolation region between adjacent second semiconductor layer and first semiconductor layer.

The preparation methods of the dielectric and semiconductor layers are not limited in the present invention, as long as the objectives of the present invention are achieved.

Optionally, the second dielectric layer and the second semiconductor layer are prepared on the backlight surface by using chemical vapor deposition. For example, high-purity oxygen is firstly introduced at 400°C to 650°C to grow the second dielectric layer, and then high-purity SiH₄ is introduced at 450°C to 700°C to prepare a second amorphous silicon layer. Finally, BCl₃ is introduced at 750°C to 1050°C for boron diffusion, the second amorphous silicon layer is crystallized and doped to form the second semiconductor layer.

The second semiconductor layer and second dielectric layer are removed by a laser and wet alkaline polishing to expose a part of the backlight surface.

The first dielectric layer and the first semiconductor layer are prepared on the backlight surface by using chemical vapor deposition. For example, high-purity oxygen is firstly introduced at 400°C to 650°C to grow the first dielectric layer, and then high-purity SiH₄ is introduced at 450°C to 700°C to prepare a first amorphous silicon layer. Finally, POCl₃ is introduced at 750°C to 1050°C for phosphorus diffusion, and the first amorphous silicon layer is crystallized and doped to form the first semiconductor layer.

The above processes not only allow the doping concentrations of the conductive elements in both the first and second semiconductor layers to be within the ranges of the present invention, but also enable the deposited film to achieve high flatness and fewer interfacial defects, thereby reducing recombination.

After preparing the first and second semiconductor layers, the light receiving surface of the silicon substrate is textured and cleaned. After texturing, the entire light receiving surface is formed with a textured structure. The presence of the textured structure is beneficial for reducing the reflection of sunlight and improving absorption to sunlight. Further, since both the first and second semiconductor layers are positioned on the backlight surface, that is, the first functional layer on the first semiconductor layer and the second functional layer on the second semiconductor layer are prepared simultaneously, the first and second functional layers on the backlight surface of the solar cell are structurally identical. The second electrode extends through the second functional layer and is connected to the second semiconductor layer via the second conductive structure. The first electrode extends through the first functional layer and is connected to the first semiconductor layer via the first conductive structure.

In a second optional embodiment, the step of providing the silicon substrate includes:
depositing a second dielectric layer and a second semiconductor layer sequentially on the light receiving surface of the silicon substrate;
removing the second dielectric layer and second semiconductor layer on the light receiving surface to expose part of the light receiving surface;
depositing a first dielectric layer and a first semiconductor layer sequentially on the backlight surface of the silicon substrate; and
removing the first dielectric layer and first semiconductor layer on the backlight surface to expose part of the backlight surface.

After preparing the first and second semiconductor layers, the light receiving surface is textured and cleaned. After texturing, the resulting structure have a textured structure only on the exposed light receiving surface. A passivation layer is then deposited, where the textured structure and second semiconductor layer that are on the light receiving surface are deposited with a second passivation layer, and the first semiconductor layer and exposed backlight surface are deposited with a first passivation layer. The second electrode extends through the second functional layer and is connected to the second semiconductor layer via the second conductive structure. The first electrode extends through the first functional layer and is connected to the first semiconductor layer via the first conductive structure.

The first functional layer can be prepared by using atomic layer deposition and/or plasma-enhanced chemical vapor deposition. The second functional layer is prepared by using plasma-enhanced chemical vapor deposition. For example, the first functional layer is prepared by using atomic layer deposition, or the first functional layer is prepared by using plasma-enhanced chemical vapor deposition. Alternatively, when the first functional layer comprises two layers, at least one is prepared by using plasma-enhanced chemical vapor deposition, and the other by using atomic layer deposition.

Additionally, in order to ensure the flatness of the first and second dielectric layers, the silicon substrate is polished and cleaned prior to the deposition of the first and second dielectric layers to remove metal ions and damage from the surface of the silicon substrate, thereby improving the photoelectric conversion efficiency of the solar cell.

In a third optional embodiment, the step of providing the silicon substrate includes:
depositing a second semiconductor layer on the light receiving surface of the silicon substrate; and
depositing a first dielectric layer and a first semiconductor layer sequentially on the backlight surface of the silicon substrate.

Prior to the step of depositing the second semiconductor layer, the light receiving surface is textured and cleaned. After texturing, the light receiving surface has a textured structure. After the step of depositing the first dielectric layer and first semiconductor layer on the backlight surface, a second passivation layer is deposited on the second semiconductor layer on the light receiving surface, and a first passivation layer is deposited on the first semiconductor layer. The second electrode extends through the second functional layer and is connected to the second semiconductor layer via the second conductive structure. The first electrode extends through the first functional layer and is connected to the first semiconductor layer via the first conductive structure.

The technical solutions of the present invention will be further described below with reference to specific examples and experimental test results.

### Example 1

This example provides a solar cell, a doping concentration of N-type conductive element in the first semiconductor layer is 5×10²⁰ atoms/cm³, and a doping concentration of P-type conductive element in the second semiconductor layer is 5×10¹⁹ atoms/cm³. In any region of 1 mm × 1 mm, the number of the first conductive structures is 5×10⁵. In any contact region of 1 mm × 1 mm between the second electrode and the second semiconductor layer, the number of the plurality of second conductive structures is 1×10⁵. A size of the projection of each first conductive structure on the first semiconductor layer is 1500 nm. A size of the projection of each second conductive structure on the second semiconductor layer is 900 nm.

This example further provides the preparation method of this solar cell as follows.

Silicon substrate is prepared, which includes:

Polishing: A N-type silicon wafer is selected as a substrate, and the surface of the N-type silicon wafer is polished to remove damage and wire marks, and to clean oil contaminations, forming a smooth and clean silicon substrate.

Forming the second dielectric layer and the second semiconductor layer: a second dielectric layer and a second semiconductor layer are prepared on the light receiving surface by using plasma chemical vapor deposition. First, high-purity oxygen is introduced at 400°C to 650°C to grow the second dielectric layer, and then high-purity SiH₄ is introduced at 450°C to 700°C to prepare a second amorphous silicon layer. Finally, BCl₃ is introduced at 750°C to 1050°C for boron diffusion, the second amorphous silicon layer is crystallized and doped to form the second semiconductor layer.

The second semiconductor layer and second dielectric layer are removed by a laser and wet alkaline polishing to expose a part of the backlight surface.

Forming the first dielectric layer and the first semiconductor layer: the first dielectric layer and the first semiconductor layer are prepared on the backlight surface by using chemical vapor deposition. First, high-purity oxygen is introduced at 400°C to 650°C to grow the first dielectric layer, and then high-purity SiH₄ is introduced at 450°C to 700°C to prepare a first amorphous silicon layer. Finally, POCl₃ is introduced at 750°C to 1050°C for phosphorus diffusion, and the first amorphous silicon layer is crystallized and doped to form the first semiconductor layer.

Texturing and cleaning: borophosphosilicate glass overplated on the light receiving surface of the silicon substrate due to boron/phosphorus diffusion is removed by a chain HF apparatus. In a tank apparatus, a textured structure is formed on the light receiving surface of the silicon substrate by using a mixture of sodium hydroxide and an additive of the model TS40 at a volume ratio of 7: 1 and maintaining a temperature at 80 °C for 7 minutes, and the thinning amount of the silicon substrate is controlled to 5 µm.

The first and second functional layers are prepared on the backlight surface of the silicon substrate by plasma-enhanced chemical vapor deposition.

The paste for preparing the first electrode is printed on the first functional layer and then dried at 200°C. Next, the paste for preparing the second electrode is printed on the second functional layer and then dried at 200°C.

Heat treatment is performed at 900°C to enable a contact interface between the first electrode and the first semiconductor layer to form a first conductive precursor, and to enable a contact interface between the second electrode and the second semiconductor layer to form a second conductive precursor.

Light injection is performed to convert the first conductive precursor to a first conductive structure and convert the second conductive precursor to a second conductive structure. The second electrode passes through the second functional layer and is connected to the second semiconductor layer via the second conductive structure. The first electrode passes through the first functional layer and is connected to the first semiconductor layer via the first conductive structure. The light injection includes:

Heating stage: the first and second conductive precursors are heated. Specifically, they are heated to 350°C, and then heated from 350°C to 500°C within 20 seconds, followed by cooled to 350°C.

When the temperature in the heating phase drops from 500°C to 350°C, the solar cell is subjected to light irradiation with an energy density of 100 kW/m² at a temperature of 200°C.

### Example 2

This example differs from Example 1 only in that in the solar cell, a doping concentration of N-type conductive element in the first semiconductor layer is 1×10²⁰ atoms/cm³, and a doping concentration of P-type conductive element in the second semiconductor layer is 9×10¹⁹ atoms/cm³.

### Example 3

This example differs from Example 1 only in that the size of the projection of each first conductive structure on the first semiconductor layer is 500 nm, and the size of the projection of each second conductive structure on the second semiconductor layer is 1000 nm.

### Example 4

This example differs from Example 1 only in that, the solar cell of this example is a passivated contact solar cell. The light receiving surface of this solar cell is partially provided with a second dielectric layer and a second semiconductor layer, and the backlight surface is partially provided with a first dielectric layer and a first semiconductor layer. The schematic structural view of the prepared solar cell can be seen in FIG. 7.

### Example 5

This Example differs from Example 1 only in that the solar cell of this example is a passivated contact solar cell. The light receiving surface of the prepared solar cell is provided with a second semiconductor layer, and the backlight surface is provided with a first dielectric layer and a first semiconductor layer. The schematic structural view of the prepared solar cell can be seen in FIG. 6.

### Comparative example 1

This Example differs from Example 1 only in that, in any region of 1 mm×1 mm, the number of the first conductive structures is 5×10⁴, and in any contact region of 1 mm×1 mm between the second electrode and the second semiconductor layer, the number of the plurality of second conductive structures is 5×10⁴.

### Comparative example 2

This Example differs from Example 1 only in that, a density of the first conductive structure is less than a density of the second conductive structure.

### Performance Testing

The solar cells prepared in Examples 1 to 5 and Comparative Examples 1 to 2 are subjected to the following relevant tests:

The performance of the solar cells provided in the present invention, including open-circuit voltage, short-circuit current, and fill factor, is tested using halm testing and sorting equipment. The halm machine is a device simulating sunlight, equipped with an electronic load, data acquisition, and calculation systems, and is used to measure the electrical performance of photovoltaic devices (including solar cells). The silicon wafers of the tested solar cells are controlled to a size of 182, with a calibrated light intensity of 1000 ± 5 W/m² and a testing temperature of 25°C±0.5°C. The experimental test results are shown below.

**Table 1 Performance Test Results of Solar Cells**

| | Open-circuit voltage (mV) | Fill factor (%) | short-circuit current density (mA/cm²) | Photoelectric conversion efficiency (%) | Series resistance (Ω·cm²) |
|---|---|---|---|---|---|
| Example 1 | 732.2 | 80.83 | 42.96 | 25.43 | 0.48 |
| Example2 | 731.8 | 80.48 | 42.88 | 25.25 | 0.55 |
| Example3 | 731.9 | 80.18 | 42.90 | 25.17 | 0.61 |
| Example4 | 730.8 | 84.12 | 40.71 | 25.03 | 1.12×10⁻³ |
| Example5 | 729.5 | 84.09 | 40.78 | 25.02 | 0.92×10⁻³ |
| Comparative example 1 | 731.5 | 79.69 | 42.73 | 24.91 | 0.86 |
| Comparative example 2 | 729.1 | 77.63 | 42.45 | 24.02 | 1.12 |

By comparing the data of Examples 1 to 3 and Comparative Examples 1 to 2, it can be inferred that the performance of the examples is superior to that of the comparative examples. This is because the density of the first conductive structure in the examples is greater than that of the second conductive structure, and both fall within the ranges of the present invention. Therefore, it contributes to enhancing the diffusion capability of carriers in the first semiconductor layer, thereby reducing the probability of carrier scattering and recombination and improving the photoelectric conversion efficiency of the solar cell.

Comparing the data of examples 1 and 2, the performance of Example 1 is higher than that of Example 2. This is attributed to the higher doping concentration of N-type conductive element in the first semiconductor layer and the lower doping concentration of P-type conductive element in the second semiconductor layer in Example 1. Consequently, the concentration of carriers in the first semiconductor layer is higher. Additionally, the concentration of carriers in the first semiconductor layer exhibits better compatibility with the density of the first conductive structure, raising the transport rate of carriers. This enhances the conductivity of the solar cell, reduces the probability of carrier recombination and scattering, and significantly improves the photoelectric conversion efficiency.

Comparing the data of Examples 1 and 3, the performance of Example 1 is superior to that of Example 3. This is attributed to a greater size of the projection of the first conductive structure in the first semiconductor layer than that of Example 3, and a smaller size of the projection of the second conductive structure in the second semiconductor layer than that of Example 3. As a result, each first conductive structure in Example 1 can transport a higher number of carriers, effectively improving carrier transport capability in the first semiconductor layer. This effectively reduces the probability of carrier scattering and recombination in the first semiconductor layer and enhances the performance of the solar cell.

After analyzing the data of Examples 1, 4, and 5, it can be inferred that for both back-contact solar cells and passivated contact solar cells (including those with passivation contact structure on both the illuminated and backlight surfaces or only on the backlight surface), as long as the density of the first conductive structure is controlled to be higher than that of the second conductive structure conduces, it is conducive to raising carrier transport rate and improving solar cell performance.

The solar cell, the preparation method therefor, and photovoltaic modules disclosed in the embodiments of the present invention, have been described in detail above. Specific examples are used to illustrate the principles and implementations of the present invention. The descriptions of the above embodiments are intended to aid in understanding the technical solutions of the present invention.

## Claims

1. A solar cell, comprising:
a silicon substrate (1);
a first semiconductor layer (21) and a second semiconductor layer (22) that are provided on the silicon substrate (1), the first semiconductor layer (21) being doped with an N-type conductive element, and the second semiconductor layer (22) being doped with a P-type conductive element;
a first electrode (31) electrically connected to the first semiconductor layer (21) through a plurality of first conductive structures (41); and
a second electrode (32) electrically connected to the second semiconductor layer (22) through a plurality of second conductive structures (42);
wherein a density of the plurality of first conductive structures (41) is greater than a density of the plurality of second conductive structures (42).

2. The solar cell according to claim 1, wherein in any contact region of 1 mm × 1 mm between the first electrode (31) and the first semiconductor layer (21), a number of the first conductive structures (41) is in a range from 1×10⁵ to 1×10⁶; and in any contact region of 1 mm × 1 mm between the second electrode (32) and the second semiconductor layer (22), a number of the plurality of second conductive structures (42) is in a range from 5×10⁴ to 5×10⁵.

3. The solar cell according to claim 1 or 2, wherein a size of a projection of each first conductive structure (41) on the first semiconductor layer (21) is greater than or equal to a size of a projection of each second conductive structure (42) on the second semiconductor layer (22), the size of the projection of the first conductive structure (41) on the first semiconductor layer (21) is in a range from 100 nm to 2000 nm, and the size of the projection of the second conductive structure (42) on the second semiconductor layer (22) is in a range from 100 nm to 1000 nm.

4. The solar cell according to any one of claims 1 to 3, wherein the first conductive structure (41) comprises a plurality of strip-shaped first structures (411) diverging toward the first electrode (31), and the second conductive structure (42) comprises a plurality of strip-shaped second structures diverging toward the second electrode (32).

5. The solar cell according to claim 4, wherein each first structure (411) comprises a first crystalline main chain (4111) and a plurality of first crystalline side chains (4112) extending in directions different from a growth direction of the first crystalline main chain (4111), and each second structure comprises a second crystallization main chain and a plurality of second crystallization side chains extending in directions different from a growth direction of the second crystallization main chain.

6. The solar cell according to claim 5, wherein the first semiconductor layer (21) and the second semiconductor layer (22) are provided on a backlight surface of the silicon substrate (1), the first semiconductor layer (21) and second semiconductor layer (22) are separated by an isolation region, and the first semiconductor layer (21) and second semiconductor layer (22) are arranged in an interdigitated shape.

7. The solar cell according to any one of claims 1 to 6, further comprising a first dielectric layer (51) provided between the first semiconductor layer (21) and the silicon substrate (1), and a second dielectric layer (52) provided between the second semiconductor layer (22) and the silicon substrate (1).

8. The solar cell according to any one of claims 1 to 7, wherein the silicon substrate (1) is an N-type substrate, the second semiconductor layer (22) is provided on a light receiving surface of the silicon substrate (1), the first semiconductor layer (21) is provided on a backlight surface of the silicon substrate (1), and the solar cell further comprises a first dielectric layer (51) provided between the first semiconductor layer (21) and the silicon substrate (1).

9. The solar cell according to claim 8, further comprising a plurality of first semiconductor layers (21) provided on the backlight surface, wherein each first semiconductor layer (21) is provided on a partial region of the backlight surface, and adjacent two first semiconductor layers (21) are separated by a first separation region (7); or
the solar cell further comprises a plurality of second semiconductor layers (22) provided on the light receiving surface, wherein each second semiconductor layer (22) is provided on a partial region of the light receiving surface, adjacent two second semiconductor layers (22) are separated by a second separation region (8), and the second separation region (8) is provided with a textured structure.

10. A method for preparing the solar cell according to any one of claims 1 to 9, comprising:
providing a silicon substrate (1);
forming a first semiconductor layer (21) and a second semiconductor layer (22) on the silicon substrate (1);
applying a first paste onto the first semiconductor layer (21) and applying a second paste onto the second semiconductor layer (22);
heating the first paste and the second paste to form a first electrode (31) and a second electrode (32), respectively, such that a contact interface between the first electrode (31) and the first semiconductor layer (21) forms a first conductive precursor, and a contact interface between the second electrode (32) and the second semiconductor layer (22) forms a second conductive precursor; and
performing light injection, such that the first conductive precursor is converted into a first conductive structure (41), and the second conductive precursor is converted into a second conductive structure (42), thereby obtaining the solar cell.

11. The method according to claim 10, wherein performing light injection comprises:
heating the first and second conductive precursors, wherein a peak temperature of the heating is in a range from 400°C to 650°C; and
subjecting the solar cell to light irradiation when a temperature of the heating drops from the peak temperature to a preset temperature;
wherein a temperature of the light irradiation is in a range from 50°C to 400°C, an energy density of the light irradiation is in a range from 10 kW/m² to 100 kW/m², and the preset temperature is in a range from 320°C to 360°C.

12. The method according to claim 11, wherein heating the first and second conductive precursors comprises:
heating the first and second conductive precursors to the preset temperature; and
heating the first and second conductive precursors from the preset temperature to the peak temperature within a preset time, and cooling the first and second conductive precursors to the preset temperature;
wherein the present time is in a range from 10 seconds to 30 seconds.

13. The method according to any one of claims 10 to 12, wherein the first conductive precursor comprises a plurality of first crystalline main chains (4111) diverging toward the first electrode (31), and the second conductive precursor comprises a plurality of second crystalline main chains diverging toward the second electrode (32).

14. The method according to any one of claims 10 to 13, wherein forming the first semiconductor layer (21) and the second semiconductor layer (22) on the silicon substrate (1) comprises:
depositing a second dielectric layer (52) and the second semiconductor layer (22) sequentially on a backlight surface of the silicon substrate (1);
patterning the second dielectric layer (52) and the second semiconductor layer (22) to expose a part of the backlight surface;
depositing a first dielectric layer (51) and the first semiconductor layer (21) sequentially on an exposed backlight surface and the second semiconductor layer (22); and
removing the first semiconductor layer (21) and the first dielectric layer (51) on the second semiconductor layer (22), and forming an isolation region between adjacent second semiconductor layer (22) and first semiconductor layer (21).

15. A photovoltaic module, comprising the solar cell according to any one of claims 1 to 9, or the solar cell prepared by the method according to any one of claims 10 to 14.
